# EUROPEAN PATENT SPECIFICATION

(11) **EP 3 499 573 B1**
(45) Date of publication and mention of the grant of the patent: **23.02.2022**
(21) Application number: 17207092.2
(22) Date of filing: 13.12.2017
(51) Int. Cl.: H01L 27/146

(54) **METHOD FOR MANUFACTURING A MICROLENS**
VERFAHREN ZUR HERSTELLUNG EINER MIKROLINSE
PROCÉDÉ DE FABRICATION D'UNE MICROLENTILLE

(43) Date of publication of application: 19.06.2019
(73) Proprietor: ams AG, 8141 Premstätten (AT)
(72) Inventor: Eilmsteiner, Gerhard, 8700 Leoben (AT); Brandner, Hannes, 8010 Graz (AT)
(74) Representative: Epping - Hermann - Fischer

(56) References cited:
- US-A1- 2005 208 432
- US-A1- 2010 187 580
- TADASHI SERIKAWA ET AL: "Modelling of lift-off sputter deposition and application to fabrication of a microlens", THIN SOLID FILMS, vol. 281-282, August 1996 (1996-08), pages 246-248, XP055469261, AMSTERDAM, NL ISSN: 0040-6090, DOI: 10.1016/0040-6090(96)08643-9
- HEE JU CHOI ET AL: "Shape-controllable, bottom-up fabrication of microlens using oblique angle deposition", OPTICS LETTERS, vol. 41, no. 14, 14 July 2016 (2016-07-14) , page 3328, XP055469281, ISSN: 0146-9592, DOI: 10.1364/OL.41.003328

## Description

The present disclosure relates to the manufacture of microlenses.

Microlenses are very small lenses, which generally have a diameter of less than 1 mm and may typically be as small as 10 µm, for instance. They are extensively used as passive optical components of optoelectronic semiconductor devices to focus or disperse radiation by refraction. A microlens consists of a material with a refractive index that is different from the refractive index of the adjacent material, so that refraction of radiation occurs at the surface of the microlens. Because of the small size, the manufacture of microlenses requires an especially high precision.

Spherical microlenses can be produced by a thermal reflow of resist, for instance. A resist layer is applied on a glass substrate or fused silica wafer and is structured into cylindrical posts. A subsequent thermal reflow of the posts yields structures having a spherical surface, owing to the surface tension. These structures can be transferred into the substrate or wafer by reactive ion etching (RIE). During this process a distortion of the initial lens shape can hardly be avoided. For some other pattern transfer methods, high processing temperatures and high pressure are needed, which can cause stress-induced distortions of the final lens shapes. Furthermore, low throughput and high processing costs are inherent problems of these complex process flows.

Hee Ju Choi et al, "Shape-controllable, bottom-up fabrication of microlens using oblique angle deposition", Optics Letters 41 (2016), p. 3328-3330 describes a method of fabricating microlenses. A glass wafer is provided with a mask formed by a negative photoresist with a pattern of cylindrical holes. The microlenses are formed in the holes by deposition of SiO₂ at different angles of incidence shaded by the photoresist. The flux of SiO₂ is controlled to obtain the desired size of the microlenses.

US 2005/0208432 A1 discloses methods of forming an array of microlenses with convex surfaces directed towards photoelements in a substrate. A layer of photoresist with openings is applied as a mask on a transparent layer, in which recesses are etched. After the photoresist is removed, the recesses are enlarged by a further etching step without using a mask, and a lens material is deposited to fill the recesses.

It is an object of the present invention to provide an effective method for the manufacture of microlenses.

This object is achieved with the method for manufacturing a microlens according to claim 1. Variants of the method derive from the dependent claims.

The method makes use of a three-dimensionally structured resist layer having an opening with an overhanging or re-entrant sidewall profile, which can be produced according to standard methods of semiconductor technology, especially using a negative photoresist and photolithography. A negative photoresist is a type of photoresist in which the portion of the photoresist that is exposed to light becomes insoluble to the developer, so that only the unexposed portion of the photoresist is dissolved by the developer.

The material that is provided for the microlense is then deposited by an evaporation technique, a sputter process or any other process that is compatible with a lift-off process. A portion of the deposited lens material forms the microlens inside the opening. The remaining portion of the deposited lens material is removed together with the residual resist by a subsequent lift-off process.

The method comprises applying a resist layer on a carrier, forming an opening with an overhanging or re-entrant sidewall in the resist layer, the carrier being uncovered in the opening, depositing a lens material, thus forming a lens on the carrier in the opening, and removing the resist layer. The resist layer may especially comprise a negative photoresist.

According to the inventive method, the overhanging or re-entrant sidewall is formed to comprise at least one step, which provides different widths of the opening in regions of different depths of the resist layer. The overhanging or re-entrant sidewall can especially be formed to comprise a plurality of steps. In other variants of the method, the overhanging or re-entrant sidewall is smooth.

In further variants of the method, the lens material is deposited by evaporation or by sputtering, especially reactive sputtering.

In a further variant the lens material is an inorganic material.

In a further variant the carrier comprises a semiconductor substrate and a dielectric on the semiconductor substrate, and the resist layer is applied on the dielectric. The dielectric may especially comprise an intermetal dielectric, in which metal layers are embedded. The dielectric may further comprise a passivation layer, which is formed on or in the intermetal dielectric, the lens being formed above an aperture of the passivation layer.

In a further variant the lens material comprises an oxide of a metal. In this variant the lens material may especially comprise at least one oxide selected from the group consisting of SiO₂, HfO₂, Nb₂O and TiO₂, for instance. Other oxides may be suitable as well. The lens material may instead be amorphous silicon or amorphous germanium, for instance. The following is a detailed description of the method in conjunction with the appended figures. The definitions as described above also apply to the following description unless stated otherwise.
- Figure 1: is a cross section of a three-dimensionally patterned resist layer on a carrier.
- Figure 2: is a cross section according to Figure 1 after the deposition of the lens material.
- Figure 3: is a cross section according to Figure 2 after the removal of the resist layer.
- Figure 4: is a diagram of the height of the lens depending on the lateral position.
- Figure 5: is a cross section of a semiconductor device including a photodiode provided with a lens that can be formed according to the described method.

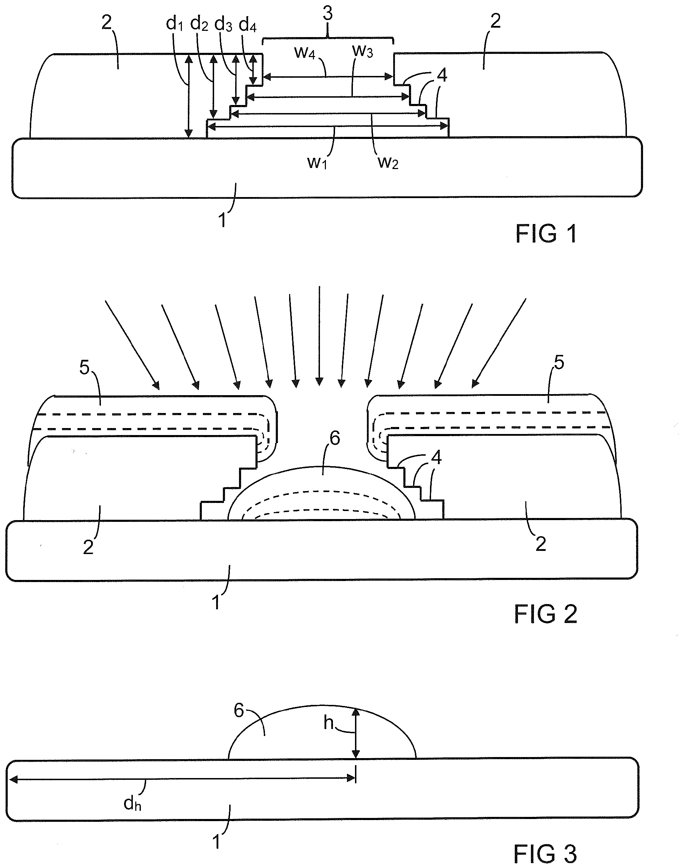

Figure 1 shows a resist layer 2 on a surface of a carrier 1. An opening 3 with an overhanging or re-entrant sidewall is formed in the resist layer 2. The opening 3 penetrates the resist layer 2, so that an area of the carrier surface is uncovered in the opening 3. In the following the term "width of the opening 3", which refers to a specified plane parallel to the carrier surface, shall mean the maximal length of all straight lines lying in the intersection of that plane and the opening 3. Because of the overhanging or re-entrant sidewall, the width of the opening 3 in a plane at a small distance from the carrier 1 is larger than the width of the opening 3 in a plane at a great distance from the carrier 1. The shape of the opening 3 may generally resemble a truncated cone. The uncovered area of the carrier surface in the opening 3 may have any geometrical shape and may in particular be circular, elliptic or polygonal, for example.

The overhanging or re-entrant sidewall may especially be formed with at least one step 4. In the example shown in Figure 1, there are three steps 4 by way of example. The number of such steps is arbitrary. The edges of the steps 4 may be rounded, and the vertical and horizontal surfaces of the steps 4 may instead be inclined, depending on the applied production process. The heights of the steps 4 can be varied. In other variants of the method, the overhanging or re-entrant sidewall of the opening 3 may be smooth.

The resist layer 2 may especially comprise a negative photoresist. Various methods of structuring negative photoresists to form an opening with an overhanging or re-entrant sidewall are well known in semiconductor technology and need not be further described. Standard lithography can be employed in these methods, for instance.

Figure 1 shows an example in which the opening 3 has three steps 4 corresponding to four different widths. A largest first width w₁ is present where the sidewall of the opening 3 reaches a first depth d₁, which is equal to the thickness of the resist layer 2. A smaller second width w₂, an even smaller third width w₃ and a smallest fourth width w₄ are present in different upper regions where the resist layer 2 only reaches a second depth d₂, a third depth d₃ and a fourth depth d₄, respectively. By adjusting the depths d₁, d₂, d₃, d₄ independently of each other in order to provide specific widths w₁, w₂, w₃, w₄ of the opening 3, which depend on the distance from the carrier 1, the shape of the lens that is produced by deposition of lens material in the opening 3 can be controlled.

Figure 2 shows how the lens material 5 is deposited to form a lens 6 in the opening 3 of the resist layer 2. A deposition process that is compatible with a later lift-off process is especially favourable. Evaporation and reactive sputtering are examples of conventional deposition methods that are suitable for the deposition of the lens material 5, but other deposition processes may be applied instead. If a sputtering process is used, for instance, the lens material is sputtered off a target and impinges on the surfaces of the carrier 1 and the resist layer 2. This is indicated by the arrows in Figure 2. Two intermediate states of the growing lens 6 and the growing layer of further lens material 5 on the resist layer 2 during this deposition process are indicated in Figure 2 by the broken lines.

The deposition can be controlled to achieve essentially isotropic deposition characteristics, in particular by setting the parameters for the sputter process, for instance. The different widths w₁, w₂, w₃, w₄ of the opening 3, which define different apertures for the deposition of the lens material 5 on the carrier 1, affect the shape of the lens 6 thus obtained, in particular the curvature of its surface. As more and more lens material 5 is deposited in the opening 3, a convex structure is built up according to the different apertures and the isotropic deposition process, until the desired shape of the lens 6 is finally obtained.

Figure 3 shows the result of a subsequent lift-off process, by which the resist layer 2 is removed together with the lens material 5 that has been deposited on the resist layer 2. The complete lens 6 now stands out on the carrier 1.

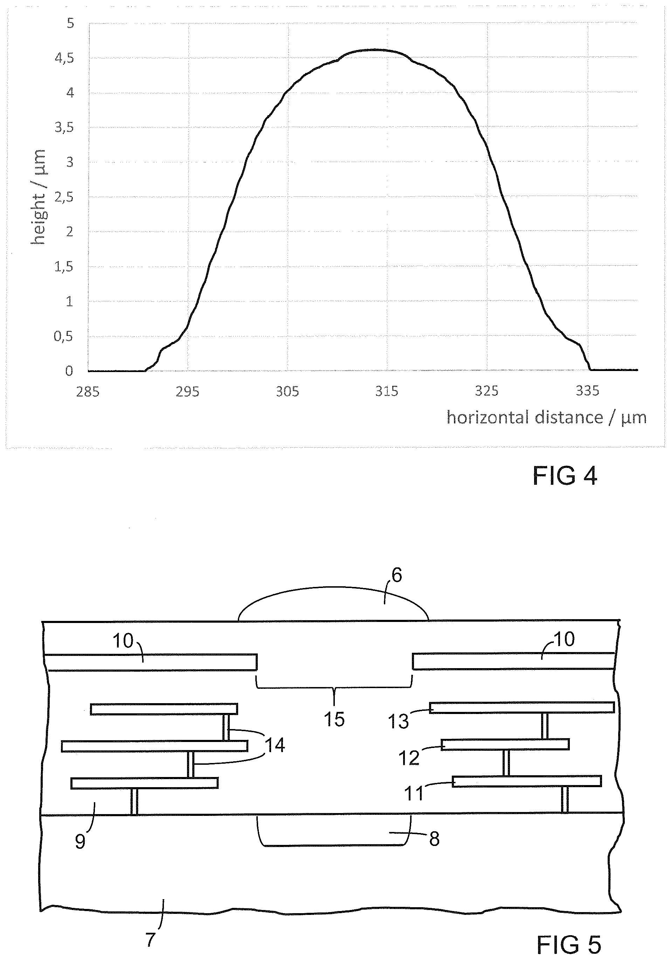

The diagram of Figure 4 shows the variation of the height h of the lens 6 as a function of the horizontal distance dₕ, as indicated in Figure 3, for an example of a cylindrical lens 6 produced by the described method, using SiO₂ as the lens material 5.

The lens 6 can be formed in a variety of geometrical shapes, depending on the patterning of the resist layer 2. The lens 6 can at least partly be spherical or cylindrical, for instance. The circumference of the lens 6 can be a circle or a polygon like a hexagon, for instance.

The optical properties of the lens 6 also depend on the lens material 5. SiO₂ can be used as the lens material 5, for instance. Sputtered SiO₂ has a refractive index of about 1.4, shows virtually no dispersion in the visible spectrum and is free of absorption down to 200 nm. Further suitable lens materials are HfO₂, Nb₂O₅ and TiO₂. HfO₂ has a refractive index of about 2.0 and is transparent down to 250 nm. Nb₂O₅ is transparent in the visible and near-infrared spectra and has a refractive index of typically 2.4. The refractive index of TiO₂ is even higher with values up to 2.5, thus providing rather short focal length even for moderately curved lenses. Refractive indices of 2.4 and higher are a prerequisite for use in a clear epoxy package with a refractive index of typically 1.55. The possibility of co-sputtering enables to deposit artificial materials having refractive indices that are not available with a single material. Amorphous silicon or amorphous germanium can also favourably be used for a lens 6 that has to be transparent in the infrared spectrum.

Figure 5 is a cross section of an example of a semiconductor device with a lens that has been produced by the described method. The semiconductor device comprises an optical component like a photodetector, for instance, which is provided with the lens. Such a semiconductor device can be produced in a CMOS process, for instance. In the example according to Figure 5, the semiconductor device has a semiconductor substrate 7 with a basic doping, which is provided with a doped region 8 of the opposite type of conductivity in order to form the pn-junction of a photodiode. If the semiconductor substrate 7 has a basic p-type conductivity, for instance, the doped region 8 may be an n-well. An intermetal dielectric 9 is applied on or above the semiconductor substrate 7, and metal layers are embedded in the intermetal dielectric 9 to form a wiring.

Figure 5 schematically shows a first metal layer 11, a second metal layer 12, a third metal layer 13 and vertical interconnections 14 between the metal layers, which do not cover the photodiode. A passivation layer 10 may be arranged in or above the intermetal dielectric 9. The passivation layer 10 may comprise an opening 15 above the photodiode, especially if the passivation layer 10 comprises a nitride of the semiconductor material, in order to avoid interferences. The passivation layer may be planarized by a further layer, which may comprise the same dielectric material as the intermetal dielectric 9, as in the example shown in Figure 5.

The described method has the advantage that it enables to manufacture microlenses from inorganic material in a relatively simple and cost effective way, which is compatible with standard CMOS processes. The method is suitable for the application of lens materials that cover a wide range of the electromagnetic spectrum and provide high refractive indices. Furthermore, the described method enables to produce lenses of different materials and shapes on the same substrate. Diameters of the lens can be in the range from a few microns to typically about 80 µm. Depending on the lens geometry, very small spacings between the lenses can be achieved, especially if a two-step method is used for the deposition. The alignment of the microlenses to the substrate is more accurate if the described method is applied instead of conventional methods of producing microlenses. The comparatively high integration density that is achieved by this method facilitates the additional deposition of coatings like anti-reflective coatings, for instance on a plurality of microlenses on the same substrate.

### List of reference numerals

- 1: carrier
- 2: resist layer
- 3: opening
- 4: step
- 5: lens material
- 6: lens
- 7: semiconductor substrate
- 8: doped region
- 9: intermetal dielectric
- 10: passivation layer
- 11: first metal layer
- 12: second metal layer
- 13: third metal layer
- 14: vertical interconnection
- 15: opening
- d₁: first depth
- d₂: second depth
- d₃: third depth
- d₄: fourth depth
- dₕ: horizontal distance
- h: height
- w₁: first width
- w₂: second width
- w₃: third width
- w₄: fourth width

## Claims

1. A method for manufacturing a microlens, comprising:
providing a carrier (1),
applying a resist layer (2) on the carrier (1),
forming an opening (3) with an overhanging or re-entrant sidewall in the resist layer (2), the carrier (1) being uncovered in the opening (3),
depositing a lens material (5), thus forming a lens (6) on the carrier (1) in the opening (3), and
removing the resist layer (2),
**characterized in that**
the overhanging or re-entrant sidewall is formed to comprise at least one step (4), which provides different widths (w₁, w₂, w₃, w₄) of the opening (3) in regions of different depths (d₁, d₂, d₃, d₄) of the resist layer (2) .

2. The method of claim 1, wherein
the resist layer (2) comprises a negative photoresist.

3. The method of one of claims 1 to 2, wherein
the overhanging or re-entrant sidewall is formed to comprise a plurality of steps (4).

4. The method of one of claims 1 to 3, wherein
the lens material (5) is deposited by evaporation.

5. The method of one of claims 1 to 3, wherein
the lens material (5) is deposited by sputtering.

6. The method of one of claims 1 to 5, wherein
the lens material (5) is an inorganic material.

7. The method of one of claims 1 to 6, wherein
the carrier (1) comprises a semiconductor substrate (7) and a dielectric (9, 10) on the semiconductor substrate (7), and the resist layer (2) is applied on the dielectric (9, 10).

8. The method of claim 7, wherein
the dielectric (9, 10) comprises an intermetal dielectric (9), in which metal layers (11, 12, 13) are embedded.

9. The method of claim 8, wherein
the dielectric (9, 10) further comprises a passivation layer (10), which is formed on or in the intermetal dielectric (9), the lens (6) being formed above an opening (15) of the passivation layer (10).

10. The method of one of claims 1 to 9, wherein
the lens material (5) comprises an oxide of a metal.

11. The method of one of claims 1 to 9, wherein
the lens material (5) comprises at least one oxide selected from the group consisting of SiO₂, HfO₂, Nb₂O₅ and TiO₂.

12. The method of one of claims 1 to 9, wherein
the lens material (5) is amorphous silicon or amorphous germanium.

## Patentansprüche

1. Verfahren zur Herstellung einer Mikrolinse, umfassend:
Bereitstellen eines Trägers (1),
Aufbringen einer Resistschicht (2) auf den Träger (1),
Ausbilden einer Öffnung (3) mit einer überhängenden oder
einspringenden Seitenwand in der Resistschicht (2), wobei der Träger (1) in der Öffnung (3) unbedeckt ist,
Abscheiden eines Linsenmaterials (5), wodurch eine Linse (6) auf dem Träger (1) in der Öffnung (3) gebildet wird, und
Entfernen der Resistschicht (2),
**dadurch gekennzeichnet, dass**
die überhängende oder einspringende Seitenwand so ausgebildet ist, dass sie mindestens eine Stufe (4) umfasst, die unterschiedliche Breiten (w1, w2, w3, w4) der Öffnung (3) in Bereichen unterschiedlicher Tiefe (d1, d2, d3, d4) der Resistschicht (2) vorsieht.

2. Verfahren nach Anspruch 1, wobei
die Resistschicht (2) einen negativen Photoresist umfasst.

3. Verfahren nach einem der Ansprüche 1 bis 2, wobei die überhängende oder einspringende Seitenwand so ausgebildet wird, dass sie eine Vielzahl von Stufen (4) umfasst.

4. Verfahren nach einem der Ansprüche 1 bis 3, wobei das Linsenmaterial (5) durch Aufdampfen abgeschieden wird.

5. Verfahren nach einem der Ansprüche 1 bis 3, wobei das Linsenmaterial (5) durch Sputtern abgeschieden wird.

6. Verfahren nach einem der Ansprüche 1 bis 5, wobei das Linsenmaterial (5) ein anorganisches Material ist.

7. Verfahren nach einem der Ansprüche 1 bis 6, wobei der Träger (1) ein Halbleitersubstrat (7) und ein Dielektrikum (9, 10) auf dem Halbleitersubstrat (7) umfasst, und
die Resistschicht (2) auf das Dielektrikum (9, 10) aufgebracht wird.

8. Verfahren nach Anspruch 7, wobei
das Dielektrikum (9, 10) ein intermetallisches Dielektrikum (9) umfasst, in das Metallschichten (11, 12, 13) eingebettet sind.

9. Verfahren nach Anspruch 8, wobei
das Dielektrikum (9, 10) ferner eine Passivierungsschicht (10) umfasst, die auf oder in dem intermetallischen Dielektrikum (9) ausgebildet ist, wobei die Linse (6) über einer Öffnung (15) der Passivierungsschicht (10) ausgebildet ist.

10. Verfahren nach einem der Ansprüche 1 bis 9, wobei das Linsenmaterial (5) ein Oxid eines Metalls umfasst.

11. Verfahren nach einem der Ansprüche 1 bis 9, wobei das Linsenmaterial (5) mindestens ein Oxid ausgewählt aus der Gruppe bestehend aus SiO₂, HfO₂, Nb₂O₅ und TiO₂ umfasst.

12. Verfahren nach einem der Ansprüche 1 bis 9, wobei das Linsenmaterial (5) amorphes Silizium oder amorphes Germanium ist.

## Revendications

1. Procédé de fabrication d'une microlentille, comprenant :
la fourniture d'un support (1),
l'application d'une couche de résist (2) sur le support (1), la formation d'une ouverture (3) avec une paroi latérale en surplomb ou rentrante dans la couche de résist (2), le support (1) étant découvert dans l'ouverture (3),
le dépôt d'un matériau de lentille (5), formant ainsi une lentille (6) sur le support (1) dans l'ouverture (3), et
l'élimination de la couche de résist (2),
**caractérisé en ce que**
la paroi latérale en surplomb ou rentrante est formée pour comprendre au moins une étape (4), qui fournit différentes largeurs (w1, w2, w3, w4) de l'ouverture (3) dans des régions de différentes profondeurs (d1, d2, d3, d4) de la couche de résist (2).

2. Procédé selon la revendication 1, dans lequel la couche de résist (2) comprend un photorésist négatif.

3. Procédé selon l'une des revendications 1 à 2, dans lequel la paroi latérale en surplomb ou rentrante est formée pour comprendre une pluralité d'étapes (4).

4. Procédé selon l'une des revendications 1 à 3, dans lequel le matériau de la lentille (5) est déposé par évaporation.

5. Procédé selon l'une des revendications 1 à 3, dans lequel le matériau de lentille (5) est déposé par pulvérisation cathodique.

6. Procédé selon l'une des revendications 1 à 5, dans lequel le matériau de lentille (5) est un matériau inorganique.

7. Procédé selon l'une des revendications 1 à 6, dans lequel le support (1) comprend un substrat semi-conducteur (7) et un diélectrique (9, 10) sur le substrat semi-conducteur (7), et la couche de résist (2) est appliquée sur le diélectrique (9, 10) .

8. Procédé selon la revendication 7, dans lequel le diélectrique (9, 10) comprend un diélectrique intermétallique (9), dans lequel des couches métalliques (11, 12, 13) sont incorporées.

9. Procédé selon la revendication 8, dans lequel le diélectrique (9, 10) comprend en outre une couche de passivation (10), qui est formée sur ou dans le diélectrique intermétallique (9), la lentille (6) étant formée au-dessus d'une ouverture (15) de la couche de passivation (10).

10. Procédé selon l'une des revendications 1 à 9, dans lequel le matériau de la lentille (5) comprend un oxyde d'un métal.

11. Le procédé selon l'une des revendications 1 à 9, dans lequel
le matériau de lentille (5) comprend au moins un oxyde choisi dans le groupe constitué de SiO₂, HfO₂, Nb₂O₅ et TiO₂.

12. Le procédé selon l'une des revendications 1 à 9, dans lequel
le matériau de lentille (5) est du silicium amorphe ou du germanium amorphe.
